# EUROPEAN PATENT APPLICATION

(11) **EP 2 604 728 A1**
(43) Date of publication of application: **19.06.2013**
(21) Application number: 11193086.3
(22) Date of filing: 12.12.2011
(51) Int. Cl.: C30B 11/00, C30B 11/14, C30B 29/06, C30B 35/00, C30B 28/06, H01L 31/18

(54) **Crucible for the production of crystalline semiconductor ingots and process for manufacturing the same**

(71) Applicant: Vesuvius France S.A., 59750 Feignies (FR)
(72) Inventor: Martin, Christian, 59750 FEIGNIES (FR); Rancoule, Gilbert, 59700 MARCQ-EN-BAROEUL (FR); Dubois, Laurent, 59131 ROUSIES (FR)
(74) Representative: Debled, Thierry

(57) **Abstract**

The present invention concerns a crucible (1) for the production of crystalline semiconductor ingots, said crucible comprising an inner volume defined by a floor (1 a) which top surface comprises a planar portion defining a first horizontal plane (H) and peripheral side walls (1b) each comprising an inner surface comprising a planar portion substantially vertical and normal to the first, horizontal plane (H), said side walls (1 b) joining the floor (1 a) at the perimeter of the latter by forming a radius of curvature, R1, of at least 1 mm, characterized in that, the intersecting line (hv) forming the intersection between the first, horizontal plane (H) and the prolongation of the vertical portion of the inner surface of each side wall (1 b) is entirely located on the side walls (1 b), on the floor (1 a), or in the inner volume of the crucible.

## Description

### FIELD OF THE INVENTION

The present invention generally relates to the production of semiconductor crystals, such as silicon, for use in photovoltaic applications. In particular, it concerns a specific crucible particularly suitable for the production of monocrystalline or quasi-monocrystalline semiconductor ingots for the production of semiconductor wafers with use of crystallization seeds.

### BACKGROUND OF THE INVENTION

Semiconductor wafers, such as silicon, are widely used in photovoltaic applications to convert photonic energy into electrical energy. Ideally, monocrystalline semiconductors, like monocrystalline silicon (MCS) are used, yielding an electrical conversion ratio of the order of 18-19%. The production of semiconductor monocrystals is, however, rather slow and expensive, typically using Czochralski drawing process. The Czochralski drawing process described e.g., in US2008/053368, US2011/214603, and W02011/083529, consists of drawing and crystallizing an ingot out of a pool of molten semiconductor. The drawing conditions must be strictly controlled to minimize the formation of defects and, in particular, the drawing rate of the ingot must be very low which increases the production cost beyond what the photovoltaic industry is ready to pay for. Semiconductor produced by the Czochralski drawing process are therefore generally used in electronic applications and seldom in photovoltaic applications.

As described e.g., in US2007/227189, a much cheaper type of semiconductor wafer is polycrystalline, such as polycrystalline silicon (PCS), generally produced using a Bridgman growth technique, wherein a pool of molten semiconductor material contained in a crucible is cooled in a controlled manner to solidify the material from the bottom of the crucible and moving up the crystal-liquid front towards the top of the crucible. To carry out such process a crucible is positioned in an oven and filled with a semiconductor feedstock. The oven is activated to melt the whole mass of feedstock. Heat is then extracted through the bottom floor with a heat sink positioned below the crucible; generally the heat sink comprises a gas flowing in pipes. By varying the gas flow rate, it is possible to control the heat extraction rate from the feedstock. As the temperature within the feedstock layer in contact with the floor reaches the crystallization temperature, crystals will start growing from the bottom floor and extend upwards, as the crystallization front proceeds. Batches of up to 500 kg can be produced using the Bridgman technique compared with about 100 kg batches with the Czochralski drawing process. When the cost of polycrystalline semiconductor ingots produced by the Bridgman technique is about a third of the one of monocrystalline ingots produced with the Czochralski technique, the conversion ratios of about 14-16% obtained with polycrystalline wafers are quite low compared with the ones obtained with monocrystalline wafers.

Recent studies have shown that monocrystalline or quasi monocrystalline semiconductor ingots could be produced using the Bridgman technique by tiling the floor of a crucible with monocrystalline seeds, which are a few millimeter to centimetre thick slabs of monocrystalline semiconductor material, obtained e.g., by the Czochralski technique. Such results are presented for example in FR2175594, W02010/005705, US2011/0146566, and US2010/0003183. The top surface of the seeds, in contact with the feedstock, should melt with the latter. Heat must be extracted from the bottom of the crucible before the bottom surface of the seeds starts melting, so that a monocrystalline ingot may grow from the partially melted seeds, taking care to maintain a stable solidification front as crystallization proceeds. The temperature profile within the crucible must therefore be controlled very accurately.

Crucibles for the growth of a crystalline ingot are generally in the shape of an open box, with a floor and usually four vertical side walls defining an interior volume and made of a silicon oxide based refractory material. The production and use conditions of such crucibles impose that no sharp edges be present, lest high stress concentrations would lead to crack formation and propagation either during manufacture or upon loading the crucibles and driving them through severe thermal cycles. For this reason, the floor of the crucible joins the vertical side walls by forming a radius of curvature. Similarly, two adjacent side walls also join by forming a radius of curvature.

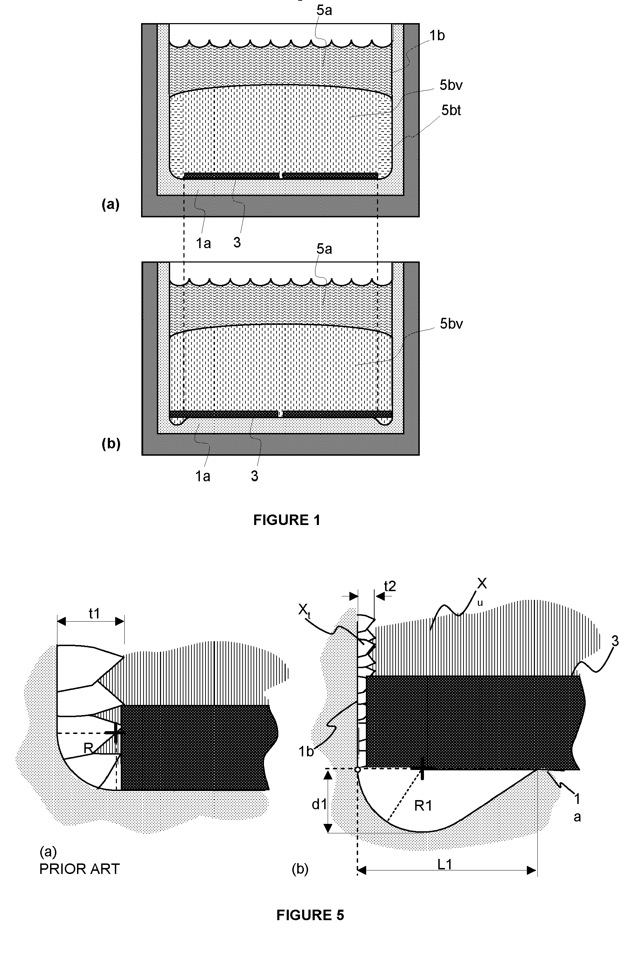

A limitation of the (quasi-) monocrystalline growth of a semiconductor ingot using a Bridgman process is that, besides the unidirectional crystals, Xᵤ, growing from the floor, transverse crystals, Xₜ, grow from the lateral walls of the crucible in a direction transverse to the general growth direction of the monocrystal as illustrated in Figure 5(a). In particular, when a monocrystal seed is used, the necessary presence of a radius of curvature at the intersection between the floor and the side walls prevents full coverage of the floor with seeds. There is thus necessarily a gap between the crucible walls and the vertically grown ingot. Transverse crystals growing from the side walls will mainly develop in this gap. A similar situation will also prevail with a polycrystalline crystal growing vertically from the bottom floor. The length, t1, of these transverse crystals may reach several cm, and their intrusion into the adjacent unidirectional crystal may create defects in lattice thereof, and must be trimmed off the ingot and melted again as they are not fit to be used for photovoltaic applications, to the detriment of the efficacy of the process.

The present invention proposes a solution for producing a (quasi-) monocrystalline semiconductor ingot by a Bridgman process with transverse crystals growing from the lateral walls of the crucible of thickness substantially lower than henceforth achieved. This and other advantages of the present invention are presented in continuation.

### SUMMARY OF THE INVENTION

The present invention is defined by the attached independent claims. The dependent claims define preferred embodiments. In particular, the present invention concerns a crucible for the production of crystalline semiconductor ingots, said crucible comprising an inner volume defined by a floor (1 a) which top surface comprises a planar portion defining a first horizontal plane and peripheral side walls each comprising an inner surface comprising a planar portion substantially vertical and normal to the first, horizontal plane, said side walls joining the floor at the perimeter of the latter by forming a radius of curvature, R1, of at least 1 mm, characterized in that, the intersecting line forming the intersection between the first, horizontal plane and the prolongation of the vertical portion of the inner surface of each side wall is entirely located on the side walls, on the floor, or in the inner volume of the crucible.

In a preferred embodiment, the radius R1 along the joint between floor and side walls is defined by a groove of width, L1, and depth, d1, extending along the perimeter of the floor and formed on the floor and/or the side walls. The groove radius, R1, is preferably comprised between 5 and 25 mm, more preferably between 10 and 17 mm, most preferably between 12 and 15 mm. The groove width, L1, is preferably comprised between 5 and 30 mm, more preferably between 10 and 20 mm, most preferably between 12 and 17 mm. The groove depth, d1, is preferably comprised between 1 and 8 mm, more preferably between 2 and 6 mm, most preferably between 3 and 5 mm.

In one embodiment, a floor groove is provided on the floor, extending along the perimeter of the latter, and preferably joining with a radius of curvature, R2, the portion of the floor which is coplanar with the horizontal plane. In an alternative embodiment some of or all the side walls (1 b) comprise a side groove extending along the perimeter of the floor, and joining with a radius of curvature, R3, the portion of each side wall which is coplanar with the vertical plane. In yet a third embodiment, the crucible comprises both such floor groove and side grooves.

As discussed above, two adjacent side walls of such crucibles normally form a corner having a radius, R4, of the order of 5 to 25 mm to prevent stresses from concentrating there. In order to facilitate the tiling of substantially the whole area of the floor with rectangular crystallization seeds, it is advantageous that the radius, R4, formed at the corner between two adjacent side walls be defined by a corner groove formed on one or both adjacent side walls extending upwards from the floor along the corner between said two adjacent walls. To simplify manufacturing of such crucibles, it is preferred that the corner groove extends from the floor to the top of the side walls. The corner grooves extending on the side walls can be of the same type as discussed above with respect to the floor grooves or side grooves extending around the perimeter of the floor.

The floor and walls of the crucible may be coated with a coating material. In a preferred embodiment, the floor comprises a floor groove extending along the perimeter of the former, said floor groove being filled with a filling material such that the filling material is flush with the horizontal plane. The filling material may be obtained by using a material selected from the group of silicon nitride (Si₃N₄), sialon, silicon oxynitride, fused quartz or fused silica, synthetic silica, silicon metals, graphite, alumina, natural or synthetic CaO-, SiO₂-, Al₂O₃-, MgO , ZrO₂- based ceramic materials or the precursors thereof (e.g., siloxane, silazane, and the like), in the form of:
- a low density layer, like a foam, of density preferably comprised between 0.3 and 1.6 g/cm³, more preferably between 0.8 and 1.3 g/cm³, or
- particulate, such as fibres, hollow shells, nanoparticles, meso-spherous particles, and mixtures thereof, each of the foregoing materials preferably having an Fe content of less than 20 ppm, more preferably less than 5 ppm, most preferably less than 1 ppm. If the floor is coated with a coating material, it can be the same as the filling material filling the floor groove.

In order to grow (quasi-) monocrystalline ingots, the floor is preferably tiled with at least one crystallization seed. It is actually preferred that substantially the whole area of the floor be tiled with more than one crystallization seeds. The advantage of a crucible according to the present invention is that the crystallization seeds may extend up to substantially each side wall by extending over a portion of the floor groove or by partly engaging in a side groove. Again, it is preferred that the floor groove be filled with a filling material in order to yield a substantially homogeneous heat flow across the whole area of the floor of the crucible, including the groove area during the crystallization step.

The present invention also concerns the use of a crucible as defined above, for the production of a crystalline semiconductor ingot, preferably of a quasi- monocrystalline ingot. A crystalline semiconductor wafer can be produced by:
- providing a crucible as discussed supra;
- forming a crystalline semiconductor ingot in said crucible by a Bridgman technique;
- extracting the ingot from said crucible and trimming off any defective layer; and
- slicing the thus trimmed ingot to form semiconductor wafers.

The semiconductor material is preferably silicon. Crystalline wafers can then be extracted from the thus produced ingot, and such crystalline wafers can be further processed to form a photovoltaic cell.

### BRIEF DESCRIPTION OF THE FIGURES

[Various embodiments of the present invention are illustrated in the attached Figures:
Figure 1: shows schematically the crystallization growth from a molten feedstock, using crystallization seeds, with a crucible (a) of the prior art and (b) according to the present invention.
Figure 2: shows schematically a side cut of the joint between floor and a side wall (a) of a crucible of the prior art, and (b) (e) of various embodiments of the present invention.
Figure 3: schematically shows a cut-off perspective view of a crucible according to the present invention.
Figure 4: schematically shows a top view of two embodiments of a crucible according to the present invention.
Figure 5: schematically shows the thickness of transverse crystals growing out of a side wall of a crucible (a) of the prior art, and (b) according to the present invention.

### DETAILED DESCRIPTION OF THE INVENTION

As can be seen by comparing a traditional crucible illustrated in Figure 1(a) with a crucible according to the present invention, an example of which being depicted in Figure 1(b), a crucible (1) according to the present invention is quite similar to crucibles used in the art for growing (quasi-) monocrystalline ingots of e.g., silicon, using a Bridgman technique. It comprises a bottom floor (1 a), and side walls (1 b) made of a silicon oxide based refractory material, such as quartz or fused silica. It may have a circular base, but it generally has a square or rectangular base. The floor and sidewalls may comprise a coating as generally used in the art of a few micrometer thick layer of, e.g., silicon nitride. The floor (1 a) of the crucible may be tiled with crystallization seeds (3) preferably covering substantially the whole area of said floor. In both types of crucibles, the floor (1 a) joins the side walls by forming a radius of curvature, R1, to prevent the formation of stress concentrations at the corners and edges. A crucible according to the present invention distinguishes itself from crucibles of the prior art in the geometry of the joint between floor (1 a) and each of the side walls (1 b). The geometry of the joint is such that a major portion of each of the intersecting lines (hv) forming the intersections between a first, horizontal plane (H) and the prolongation (V) of the vertical portion of each side wall (1 b) is located on the side walls (1 b), on the floor (1 a), or in the inner volume of the crucible. The horizontal plane (H) is defined by the planar portion of the top surface of the floor (1 a).

This geometry has the advantage that crystallization seeds used for growing (quasi-) monocrystalline ingots can cover substantially the whole area of the floor (1 a), as can well be seen by comparing the prior art crucible in Figures 1(a) and 5(a) with crucibles according to the present invention in Figures 1(b) and 5(b). In traditional crucibles cf. (Figures1(a) and 5(a)), the crystallization seeds, which must lie horizontally on the floor to ensure good thermal contact with the floor (1 a) of the crucible, can only cover the horizontal portion of the floor and must stop short before the radius, R, starts. Indeed, in traditional crucibles, the floor starts rising at the joint with the side walls to form a radius of curvature R. The seeds must therefore be separated from the side walls (1 b) by a distance of at least R (R is generally of the order of 5 to 20 mm). On the other hand, in a crucible according to the present invention, the crystallization seeds (3) can extend up to the very side walls as can be seen in Figures 1 (b) and 5(b). This apparently small difference has significant effects on the efficacy of the production of (quasi-) monocrystalline ingots. As schematically illustrated in Figure 5(a), as heat is being evacuated through the bottom floor, unidirectional crystals, Xᵤ, will grow upwards starting from the molten surface of the seeds (3), but transverse crystals, Xₜ, will also grow sidewards starting from the side walls (1 b). The advancing thermal front is controlled such as to have a flat or, preferably convex shape (cf. Figure 1(a)&(b)) which promotes the growth of the vertical crystals, Xᵤ, to the detriment of the lateral crystals, Xₜ, but the latter may still grow over a distance, t1, of a few centimetres, and disrupt the unidirectional crystal lattice over some distance in the ingot. It follows that each lateral side of an ingot must be trimmed over a few centimetres before cutting wafers therefrom, which represents a serious limitation to the efficacy of the process.

If the horizontal plane (H) and the prolongation (V) of the vertical portion of the inner surface of each side wall (1 b) intercept (hv) each other inside the inner volume of the crucible (1) or on the floor or corresponding side wall, the seeds (3) may cover substantially the whole area of the floor (1 a), quite close to, if not in contact with the side walls (1 b) as illustrated in Figure 5(b). In these conditions it has been observed that the size, t2, of the lateral crystals, Xₜ, was substantially smaller than the crystals size, t1, obtained with prior art crucibles (compare Figures 5(a)&(b)). The size reduction of the lateral crystals, Xₜ, represents a substantial economy over the prior art process, because the thickness an ingot must be trimmed for the production of photovoltaic quality wafers is controlled by the largest of the lateral crystals, Xₜ. and the amount of high value scrape material is reduced accordingly. Furthermore, transverse crystal of larger dimensions will disrupt the lattice of the unidirectional crystal over a greater depth than small sized transverse crystals. It is clear that the scrape material can be re-used as feedstock and melted again, but this process is quite energy consuming.

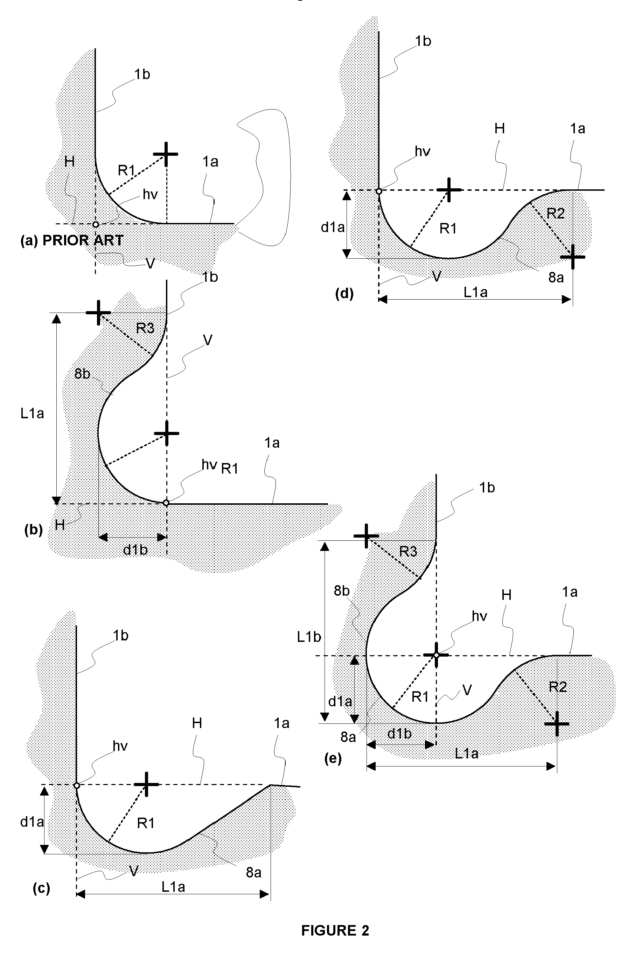

The intercepting line (hv) between the horizontal plane (H) defined by the planar portion of the floor (1 a) top surface with the prolongation of the vertical portion (V) of the inner surface of each side wall (1 b) can be included inside the inner volume of the crucible (1) or on the floor or corresponding side wall by defining the radius R1 along the joint between floor (1 a) and side walls (1 b) by a groove (8a, 8b) of width, L1 (L1a, L1b) and depth, d1 (d1 a, d1 b) extending along the perimeter of the floor (1 a) and formed on the floor (1 a) and/or on the side walls (1 b). Different embodiments of such grooves are illustrated in Figure 2(b) (e) compared with a traditional crucible in Figure 2(a). Typical values of a groove radius, R1, are comprised between 5 and 25 mm, preferably between 10 and 17 mm, more preferably between 12 and 15 mm. A groove may have a width, L1, comprised between 5 and 30 mm, preferably between 10 and 20 mm, more preferably between 12 and 17 mm. A typical groove depth, d1, is comprised between 1 and 8 mm, more preferably between 2 and 6 mm, most preferably between 3 and 5 mm.

As illustrated in Figure 2(c)&(d), the floor (1 a) may comprise a floor groove (8a) extending along the perimeter of the former. In a preferred embodiment, the floor groove (8a) joins with a radius of curvature, R2, the portion of the floor (1 a) which is coplanar with the horizontal plane (H). In an alternative embodiment, illustrated in Figure 2(b), all the side walls (1 b) comprise a side groove (8b) extending along the perimeter of the floor (1 a). Like the floor groove (8a) each side groove (8b) may join with a radius of curvature, R3, the portion of each side wall (1 b) which is coplanar with the vertical plane (V). Finally, both floor (1 a) and each of the side walls (1 b) may be provided with a floor groove (8a) and a side groove (8b), respectively, extending along the perimeter of the floor (1 a) as illustrated in Figure 2(e).

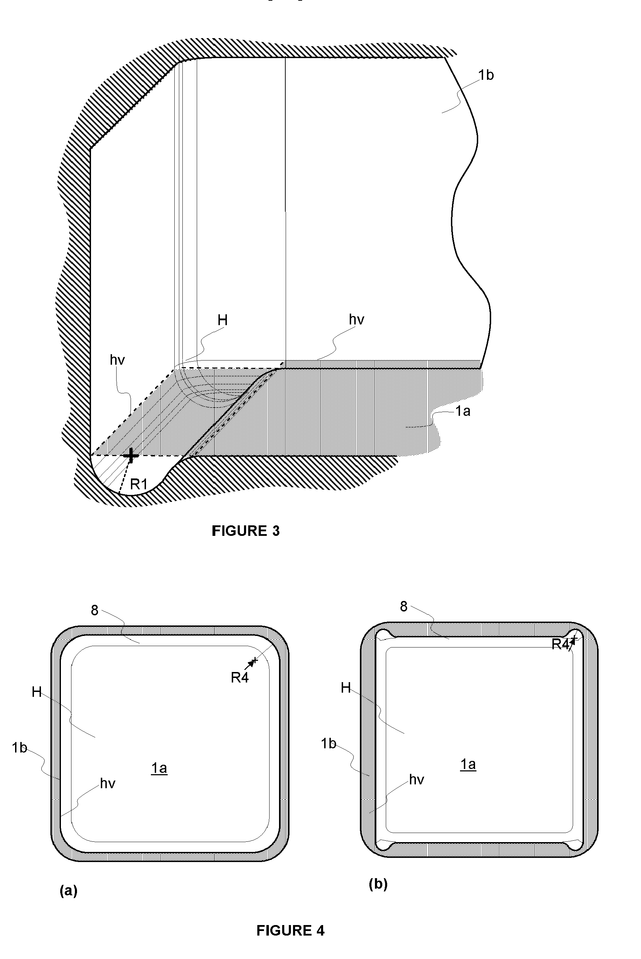

Since the corners between two adjacent side walls generally form a radius, R4, as illustrated in the top view of Figure 4(a), a square or rectangular crystallization seed covering a floor portion comprising such corner should be separated from the side walls by a distance of at least R4. This problem can be solved by cutting the corner(s) of the seeds that will cover a corner portion of the floor with a matching radius, R4, so that such corner seeds can tile the whole corner area. An alternative solution is illustrated in Figure 4(b) wherein the side walls (1 b) of the crucible may be provided with a groove similar to the floor groove (8a) and/or side groove (8b) discussed supra, but extending upwards from the floor along the intersection between two adjacent side walls (1 b). For ease of processing it is preferred that such grooves extend from the floor to the top of the side walls, but this is not mandatory, as long as they extend up to a height superior to the thickness of a crystallization seed.

It is well known that the floor and side walls of a crucible may be coated with a layer of a coating material such as e.g., silicon nitride to reduce the interactions between the crucible material and the highly reactive molten feedstock. In order to control the shape and speed of the advancing crystallization front (cf. Figure 1), it is important that the heat be withdrawn through the floor (1 a) in a controlled and homogeneous manner. Since air is a good insulator, the heat flow from a crystallization seed (3) through the floor (1 a) will be at a higher rate in the planar portion of the floor, where good thermal contact can be ensured with the seed (3) than over the groove, wherein an air pocket separates the seed lower surface from the floor top surface (cf. Figure 5(b)). For this reason, it can be advantageous to fill a floor groove (8a) with a filling material, such as to homogenize the heat flow from the crystallization seed through the floor over the whole area of the floor. The filling material should be flush with the planar portion of the floor, to ensure a good and homogeneous thermal contact with the crystallization seeds over the whole area of the floor. The filling material or precursor thereof can be one or more of silicon nitride (Si₃N₄), sialon, silicon oxynitride, siloxane, silazane, fused quartz or fused silica, synthetic silica, silicon metals, graphite, alumina, natural or synthetic CaO-, SiO₂-, Al₂O₃-, MgO-, ZrO₂-based ceramic materials in the form of:
- a low density layer, like a foam, of density preferably comprised between 0.3 and 1.6 g/cm³, more preferably between 0.8 and 1.3 g/cm³, or
- particulate, such as fibres, hollow shells, nanoparticles, meso-spherous particles,
   and mixtures thereof, each of the foregoing materials preferably having an Fe content of less than 20 ppm , more preferably less than 5 ppm, most preferably less than 1 ppm. If the floor or side walls are coated with a coating material, it is preferred that the filling material be the same or similar to the coating material.

The present crucible is advantageous for use with a crystallization seed (3). A crystallization seed (3) is a crystalline plate of thickness of about 5 to 25 mm, preferably, 8 to 15 mm, more preferably 10 to 12 mm. A thinner seed is advantageous in terms of cost, in particular if it is monocrystalline, and in terms of heat extraction rate. It is, however, more problematic to control that the upper surface of the seed be molten, whilst not the bottom, as the thickness of the seed decreases. The optimal thickness of the crystallization seeds for a given application therefore depends on the skill of the operator, and on the equipment used. Such crystallization seeds are preferably a monocrystalline semiconductor, for growing (quasi-) monocrystalline semiconductor ingots. A crucible according to the present invention is most advantageous when the crystallization seed (3), or preferably several such crystallization seeds (3) positioned side by side, tile substantially the whole area of the crucible floor (1 a), substantially in contact with, or very close to the side walls. In case of a floor groove (8a) provided on the floor (cf. Figure 2(c)&(d)) a crystallization seed (3) can reach a side wall by extending over the floor groove (8a) (cf. Figure 5(b)). In case of a side groove (8b) provided on a side wall, a crystallization seed may extend up to and even beyond the vertical plane (V) defined by the planar portion of said side wall (provided the crystallization seed is thinner than the length (L1b) of said side groove (8b)). As illustrated in Figure 5, this allows a substantial reduction of the size, t2, of the transverse crystals, Xₜ, growing from the side walls (1 b) upon crystallization (5b) of the molten feedstock (5a).

A crucible according to the present invention is suitable for the production of crystalline semiconductor ingots. Because it allows for a greater portion of the floor area to be covered by crystallization seeds (3) it is particularly suitable for the production of (quasi-) monocrystalline ingots. In particular, it can be used for the production of silicon ingots.

A (quasi-) monocrystalline ingot can therefore advantageously be produced with the following steps.
(a) providing a crucible as discussed above, and laying at least one crystallization seed (3) onto the floor (1 a) (cf. Figure 1 (b)); it is much preferred that substantially the whole area of the crucible floor (1 a) be tiled by at least two crystallization seeds positioned side by side, with their top surfaces preferably substantially parallel to each other, and more preferably coplanar and covering substantially the whole area of the floor, close to or against the side walls (1 b);
(b) filling the crucible with a load of semiconductor material feedstock;
(c) controlling the temperature in the crucible to ensure that the feedstock is completely molten (5a) and the top surface only of the at least one crystallization seed is molten too;
   furnaces specifically designed for a Bridgman process and provided with a heat sink and accurate temperature control systems are available on the market;
(d) extracting heat through the floor of the crucible to prevent the bottom surface of the at least one crystallization seed from melting and to initiate the oriented crystallization (5b) of the feedstock (cf. Figure 1(b)).

A thus crystallized ingot can then be extracted from the crucible. The crucible may have to be broken in case the base of the ingot extends laterally in a side groove (8b), but this is not a drawback because such crucibles are only seldom re-usable. A defective layer must be trimmed off the sides of the ingot. The thickness of such defective layer corresponds to the length of the transverse crystals, Xₜ, and the zone of the unidirectional crystal, Xᵤ, which lattice is disrupted by the intruding transverse crystals. Thanks to the original design of the present invention, the thickness of such disruptive layer is reduced from several centimetres as experienced with traditional crucibles, to a few millimetres to a couple of centimetres, only with a crucible according to the present invention. The thus trimmed off ingot is ready for being cut into thin slices to produce wafers. With silicon, such wafers are suitable for use as photovoltaic cells.

A crucible according to the present invention can be produced as traditionally performed with standard crucibles, by providing a female cavity mould and a male plunger defining the inner volume of the crucible. When introduced into the female cavity, the male plunger leaves a space corresponding to the desired thickness of the crucible. A slip of refractory material, generally based on silicon oxide such as fused silica, is poured into the space between female and male parts of the tool. The tool and refractory are heated and then fired to set the refractory material. The plunger is then withdrawn and the crucible extracted from the female cavity. In case of a crucible comprising a floor groove (8a) only, the plunger can be withdrawn without any difficulty. In case the crucible comprises a side groove (8b) the withdrawal of the plunger requires specific measures. For example, the part of the plunger forming the side groove may be made of a material that degrades upon firing. In this manner, the prismatic portion of the plunger that remains after firing can be withdrawn as well known in the art. In another embodiment, the male plunger can be an assembly of a central, prismatic part, and peripheral parts which together define the inner volume of the crucible. Upon demoulding, the assembled plunger can be disassembled and the central, prismatic part can be withdrawn first. Each peripheral part can be first shifted towards the centre of the floor and then withdrawn vertically out of the crucible.

## Claims

1. Crucible (1) for the production of crystalline semiconductor ingots, said crucible comprising an inner volume defined by a floor (1 a) which top surface comprises a planar portion defining a first horizontal plane (H) and peripheral side walls (1b) each comprising an inner surface comprising a planar portion substantially vertical and normal to the first, horizontal plane (H), said side walls (1 b) joining the floor (1 a) at the perimeter of the latter by forming a radius of curvature, R1, of at least 1 mm, **characterized in that**, the intersecting line (hv) forming the intersection between the first, horizontal plane (H) and the prolongation of the vertical portion of the inner surface of each side wall (1 b) is entirely located on the side walls (1 b), on the floor (1 a), or in the inner volume of the crucible.

2. Crucible according to claim 1, wherein the radius R1 along the joint between floor (1 a) and side walls (1 b) is defined by a groove (8a, 8b) of width, L1 (L1a, L1b), and depth, d1 (d1 a, d1 b) extending along the perimeter of the floor (1 a) and formed on the floor (1 a) and/or the side walls (1 b), and wherein the groove radius, R1, is preferably comprised between 5 and 25 mm, the groove width, L1, is preferably comprised between 5 and 30 mm, and/or the groove depth, d1, is preferably comprised between 1 and 8 mm.

3. Crucible according to the preceding claim, wherein the floor (1 a) comprises a floor groove (8a) extending along the perimeter of the former, and preferably joining with a radius of curvature, R2, the portion of the floor (1 a) which is coplanar with the horizontal plane (H).

4. Crucible according to claim 2 or 3, wherein all the side walls (1 b) comprise a side groove (8b) extending along the perimeter of the floor (1 a), and joining with a radius of curvature, R3, the portion of each side wall (1 b) which is coplanar with the vertical plane (V).

5. Crucible according to any of the preceding claims, wherein two adjacent side walls (1 b) form a corner having a radius, R4, defined by a corner groove formed on one or both adjacent side walls (1 b) extending upwards from the floor along the corner between said two adjacent walls, the corner groove extending preferably from the floor to the top of the side walls (1 b).

6. Crucible according to any of the preceding claims, wherein the floor (1 a) and/or the side walls (1 b) are coated with a coating material.

7. Crucible according to any of claims 2 to 6, wherein the floor (1 a) comprises a floor groove (8a) extending along the perimeter of the former, said floor groove (8a) being filled with a filling material such that the filling material is flush with the horizontal plane (H), wherein said filling material is preferably selected from the group of silicon nitride (Si₃N₄), sialon, silicon oxynitride, fused quartz or fused silica, synthetic silica, silicon metals, graphite, alumina, natural or synthetic CaO-, SiO₂-, Al₂O₃-, MgO-, ZrO₂-based ceramic materials in the form of:
- a low density layer, like a foam, of density preferably comprised between 0.3 and 1.6 g/cm³, more preferably between 0.8 and 1.3 g/cm³, or
- particulate, such as fibres, hollow shells, nanoparticles, meso-spherous particles, and mixtures thereof, each of the foregoing materials preferably having an Fe content of less than 20 ppm, more preferably less than 5 ppm, most preferably less than 1 ppm.

8. Crucible according to claims 6 and 7, wherein the floor (1 a) is coated with a coating material which is the same as the filling material filling the floor groove (8a).

9. Crucible according to any of the preceding claims, wherein the floor (1 a) is tiled with at least one crystallization seed (3), preferably, substantially the whole area of the floor (1 a) is tiled with more than one crystallization seeds (3).

10. Crucible according to the preceding claim, wherein the crystallization seeds (3) extend over a portion of the floor groove (8a).

11. Use of a crucible according to any of the preceding claims, for the production of a crystalline semiconductor ingot, preferably of a silicon ingot, more preferably of a quasi-monocrystalline silicon ingot.

12. Process for the manufacturing of a crystalline semiconductor wafer comprising the following steps:
(a) providing a crucible according to any of claims 1 to 10;
(b) forming a crystalline semiconductor ingot in said crucible by a Bridgman technique, wherein the semiconductor is preferably silicon;
(c) extracting the ingot from said crucible and trimming off any defective layer; and
(d) slicing the thus trimmed ingot to form semiconductor wafers.

13. Process according to the preceding claim, wherein the crystalline wafers are further integrated into a photovoltaic cell.
